(19) Europäisches Patentamt
European Patent Office
Office européen des brevets

(11) **EP 3 499 564 A1**

(12) **EUROPEAN PATENT APPLICATION**

(43) Date of publication:
**19.06.2019 Bulletin 2019/25**

(51) Int Cl.:
*H01L 23/40* *(2006.01)* *H05K 1/02* *(2006.01)*

(21) Application number: **17207665.5**

(22) Date of filing: **15.12.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Nokia Technologies Oy**
**02610 Espoo (FI)**

(72) Inventors:
• HUTTUNEN, Jari
  **90540 Oulu (FI)**
• AVIST, Matti
  **90540 Oulu (FI)**

(74) Representative: **Nokia EPO representatives**
**Nokia Technologies Oy**
**Karaportti 3**
**02610 Espoo (FI)**

(54) **INTEGRATED CIRCUIT PACKAGE AND FASTENER**

(57) An apparatus is disclosed comprising an integrated circuit package, wherein the integrated circuit package comprises a case containing at least one integrated circuit and a fastener configured to fasten the case to a heat sink. A system comprising the apparatus and a heat sink, and a method comprising providing the apparatus and fastening a heat sink to the case of the apparatus are also disclosed.

EP 3 499 564 A1

## Description

### Field

This specification relates generally to an integrated circuit package and fastener.

### Background

Integrated circuits (ICs) such as a System on a Chip (SoC) generate heat during operation. This heat may be dissipated to the surrounding environment through the provision of a heat sink. Manufacturing tolerances lead to the presence of a gap between the case of the package containing the integrated circuit and the heat sink. This gap may be filled with a thermal interface material (TIM), which enhances the thermal coupling between the integrated circuit package and the heat sink.

Heat generation in integrated circuits such as System on a Chip generally increases with the implantation of smaller line width processors and increased integration. This heat is dissipated to prevent the integrated circuit from overheating.

### Summary

According to a first aspect, there is provided an apparatus comprising an integrated circuit package, wherein the integrated circuit package comprises a case containing at least one integrated circuit and a fastener configured to fasten the case to a heat sink.

The fastener may be integrally formed with the case.

The fastener may be directly mounted on the case.

The fastener may be mounted on the case by an adhesive.

The fastener may comprise at least one screw configured to fasten the case to the heat sink.

The fastener may comprise a plurality of screws arranged adjacent a periphery of an upper surface of the case and configured to fasten the case to the heat sink.

The fastener may comprise at least one female screw thread configured to fasten the case to the heat sink.

The fastener may comprise at least one aperture, wherein the at least one aperture is configured to receive a screw to fasten the case to the heat sink.

The integrated circuit package may further comprise a lid, wherein the lid is mounted on the case, and wherein the lid comprises the fastener.

The fastener may comprise a plurality of apertures arranged around a periphery of the lid and configured to each receive a respective screw to fasten the case to the heat sink.

The lid may comprise a metal plate, a heat pipe or a vapour chamber.

The apparatus may further comprise a layer of thermal interface material between the case and the lid.

The integrated circuit may be a System on a Chip (SoC).

According to a second aspect, there is provided a system comprising an apparatus as disclosed herein and a heat sink fastened to the case of the apparatus using the fastener of the apparatus.

According to a third aspect, there is provided a method comprising providing an apparatus as disclosed herein and fastening a heat sink to the case of the apparatus using the fastener of the apparatus.

### Brief Description of the Figures

For a more complete understanding of the apparatuses, systems and methods described herein, reference is now made to the following description taken in connection with the accompanying drawings in which:

Figure 1A is a perspective view of an integrated circuit package containing an integrated circuit suitable for use in exemplary embodiments;
Figure 1B is a perspective view of an integrated circuit package containing an integrated circuit suitable for use in exemplary embodiments;
Figure 1C is a schematic cross-sectional view of the integrated circuit package of Figure 1B;
Figure 1D is a schematic cross-sectional view of a flip chip ball grid array integrated circuit package suitable for use in exemplary embodiments;
Figure 2 is a cross-sectional illustration of a heat sink mounted on a board for dissipating heat from an integrated circuit package;
Figure 3 is a cross-sectional illustration of an integrated circuit package fastened to a heat sink in accordance with exemplary embodiments;
Figure 4 is an exploded perspective view of an integrated circuit package fastened to a heat sink in accordance with exemplary embodiments;
Figure 5A is a cross-sectional illustration of the integrated circuit package and heat sink shown in Figure 4 after fastening;
Figure 5B is a cross-sectional perspective illustration of the integrated circuit package and heat sink shown in Figure 4 after fastening;
Figure 6A is a cross-sectional illustration of an integrated circuit package and a heat sink;
Figure 6B is a cross-sectional illustration of an integrated circuit package fastened to a heat sink in accordance with exemplary embodiments;
Figure 6C is a cross-sectional illustration of an integrated circuit package fastened to a heat sink in accordance with exemplary embodiments.

### Detailed Description

In the description and drawings, like reference numerals may refer to like elements throughout.

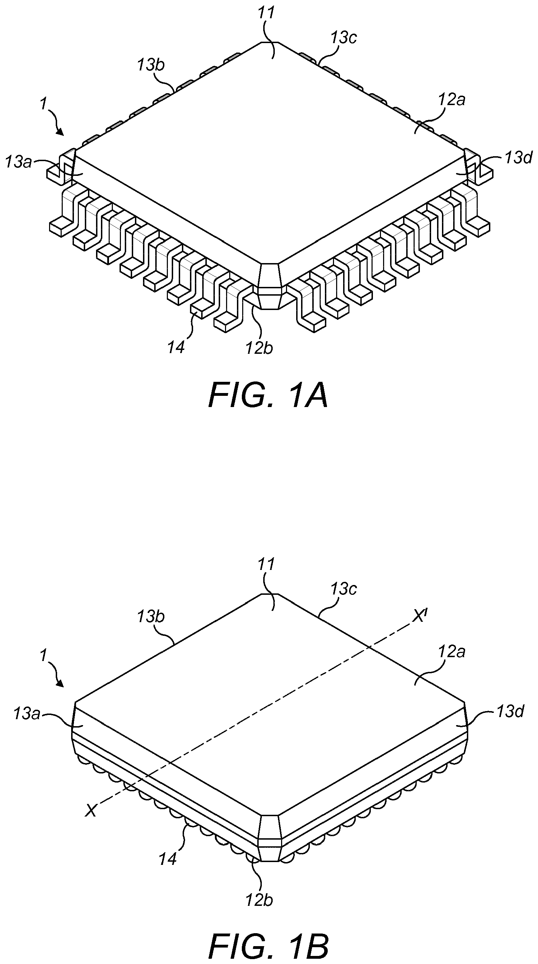

Figure 1A is a perspective view of an exemplary integrated circuit package 1. The integrated circuit package 1 comprises a case 11, which contains at least one integrated circuit comprising a die (not shown). The case 11 of the integrated circuit package 1 is configured to protect the integrated circuit from physical damage and corrosion. The case 11 of the integrated circuit package 1 comprises an upper surface 12a and a lower surface 12b. The upper surface 12a and the lower surface 12b may be flat and arranged parallel to each other such that the upper surface 12a is opposite the lower surface 12b. The case 11 may be moulded around the integrated circuit, and may be made of plastic or ceramic, or other suitable materials exhibiting good thermal conductivity and strength.

Figure 1A shows the case 11 further comprising four side surfaces 13a, 13b, 13c and 13d, each adjacent the upper surface 12a and the lower surface 12b, however the case 11 may have more or fewer sides than this. A plurality of pins 14, also known as legs, protrude from the sides 13a, 13b, 13c and 13d and extend downwards, away from the upper surface 12a. The pins 14 may be made from metal and are configured to be mounted on a board such as a printed circuit board (not shown) such that the integrated circuit package 1 is fastened to the board. The pins 14 may be soldered to the board. The pins 14 are configured to provide an electrical connection between the integrated circuit contained within the integrated circuit package 1 and one or more conductive components on the board.

The configuration of the pins 14 shown in Figure 1A is by way of example only, and other known configurations may be used. For example, the plurality of pins 14 may extend from only two, opposite sides of the case 11 (such as for a dual in-line package). In other examples, the pins 14 may protrude from the lower surface 12b of the case 11. The term pins 14 should be taken to also include similar connectors such as pads or balls, as used in a ball grid array, for example.

Figure 1B shows a ball grid array (BGA) integrated circuit package 1. The integrated circuit package 1 of Figure 1B is similar to the integrated circuit package 1 of Figure 1A, however here the plurality of pins 14 project from the lower surface 12b of the case 11. The plurality of pins 14, in this case comprising balls, are arranged in an array across the lower surface 12b of the case. As for the integrated circuit package 1 of Figure 1A, the pins 14 may be soldered to a board, and are configured to provide an electrical connection between the integrated circuit contained within the integrated circuit package 1 and one or more conductive components on the board. The ball grid array arrangement allows a higher density of pins 14 to be present on the integrated circuit package 1.

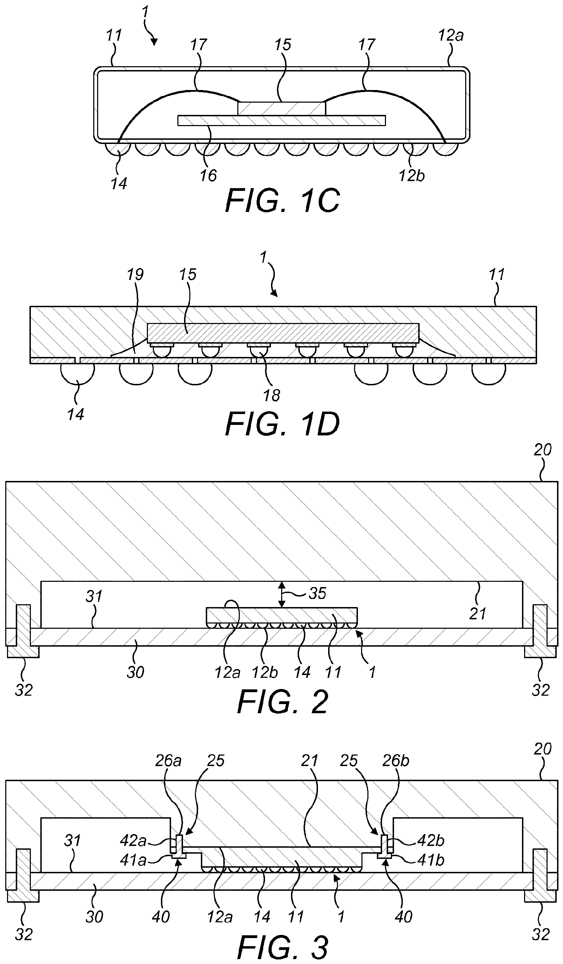

Figure 1C shows a schematic cross-sectional view of the integrated circuit package 1 of Figure 1B, along the line X-X' of Figure 1B, however the configuration will be similar for the integrated circuit package of Figure 1A.

The integrated circuit comprises a die 15, which is mounted on a substrate 16 and is electrically connected to the pins 14 by respective bond wires 17.

The integrated circuit package 1 illustrated in Figure 1C is by shown by way of example, and other types and configurations of integrated circuit package 1 may be used with embodiments of the present disclosure. For example, the integrated circuit package 1 may be of a flip chip type, as illustrated in Figure 1D.

Figure 1D shows an exemplary flip chip ball grid array package 1 suitable for use with the present disclosure. The general structure is similar to that shown in Figure 1C. However in the flip chip package 1 shown in Figure 1D, the die 15 is upside down relative to the die 15 shown in Figure 1C, with the die 15 being electrically connected to the pins 14 (in this case the pins 14 being balls of a ball grid array) via solder balls 18 instead of bond wires 17. The solder balls 18 are in a gap between the die 15 and a substrate 16. The remainder of the gap may be at least partially filled with an underfill 19, for example made from epoxy. The top of the die 15 may be covered by a lid such as a mould cap, forming the case 11 of the package 1. Heat from the die 15 may therefore be dissipated directly to the lid. Instead of a mould, the lid may be a metal lid covering the die 15, in some cases with a layer of thermal grease between the die 15 and metal lid.

During use, electrical energy supplied to the integrated circuit is converted into heat energy, which is dissipated through the case 11 of the integrated circuit package 1 to the outside. If the heat is not dissipated efficiently enough, there is a risk of the integrated circuit overheating. This may be a concern for System on Chip (SoC) integrated circuits, which comprise dense integration providing a computer on a single chip. Thus the heat output by a System on Chip may be high in comparison to simpler integrated circuits.

Figure 2 illustrates a current solution for dissipating heat from an integrated circuit using a heat sink 20. An integrated circuit is contained within the integrated circuit package 1. The package 1 is mounted on a board 30 such as a printed circuit board, for example by soldering or another known means. The package 1 is mounted such that the lower surface 12b of the case 11 is adjacent an upper surface 31 of the board 30.

The heat sink 20 may be mounted directly to the board 30 using screws 32 such that a lower surface 21 of the heat sink 20 is adjacent the upper surface 12a of the case 11 of the integrated circuit package 1. By mounting the heat sink 20 to the board 30 in this way, a gap 35 may be formed between the integrated circuit package 1 and the heat sink 20, in this case between the upper surface 12a of the case 11 of the integrated circuit package 1 and the lower surface 21 of the heat sink 20. This gap 35 may be the result of tolerances in the dimensions of various components such as the board 30, screws 32, integrated circuit package 1 and heat sink 20.

The size of the gap 35 may vary greatly with the tolerances of the board 30, screws 32, integrated circuit package 1 and heat sink 20.

The gap 35 may be filled with air, which generally has lower thermal conductivity than the case 11 of the integrated circuit package 1 and heat sink 20. The result is that heat transfer from the integrated circuit package 1 to the heat sink 20 via the gap 35 may be inefficient. A layer of thermal interface material (not shown) may therefore be used to fill the gap 35 to compensate for the tolerances. The thermal interface material is a thermally conductive material such as a thermal paste, and provides a thermal coupling between the case 11 of the integrated circuit package 1 and the heat sink 20, in particular between the upper surface 12a of the case 11 and the lower surface 21 of the heat sink 20. Heat may therefore be more efficiently transferred between the integrated circuit package 1 and the heat sink 20 than if the gap were filled only with air.

The thickness of the layer of thermal interface material depends on the magnitude of the tolerances and the type of thermal interface material used. The thickness of the layer of thermal interface material should be selected so that it fills the gap 35 without exerting too much stress on the package 1 or board 30.

The thermal resistance of the gap 35 may be reduced by selecting a thermal interface material with a higher thermal conductivity or by trying to minimise the tolerances. However, as heat generation has increased with the increased miniaturisation of integrated circuits, the development of more thermally conductive thermal interface materials has not necessarily kept pace. Furthermore, highly thermally conductive thermal interface materials tend to be harder, so they may need a larger gap 35 to operate and to minimise compression stress on components of the board 30.

Figure 3 illustrates an apparatus according to exemplary embodiments.

The apparatus comprises an integrated circuit package 1, which comprises a case 11 containing at least one integrated circuit, as described in relation to Figure 1A, Figure 1B, Figure 1C, and Figure 1D. The package 1 may be mounted on a board 30 such as a printed circuit board, for example by soldering or another known method.

The integrated circuit package 1 also comprises a fastener 40. The fastener 40 is configured to fasten the case 11 of the integrated circuit package 1 to a heat sink 20. The case 11 is fastened to the heat sink 20 such that they are attached together, and hence the integrated circuit package 1 and heat sink 20 are attached together. Heat can therefore be transferred from the integrated circuit to the heat sink 20, via the case 11.

In some examples, the fastener 40 may be configured to fasten the case 11 to the heat sink 20 reversibly, such that the case 11 and heat sink 20 may be unfastened at a later stage. In other examples, the fastener 40 may be configured to fasten the case 11 to the heat sink 20 permanently, such that the case 11 and heat sink 20 cannot be unfastened using reasonable force.

The fastener 40 may be configured to mechanically cooperate with a corresponding feature of the heat sink 20 so that the case 11 is fastened to the heat sink 20.

Figure 3 shows the fastener 40 fastening the case 11 to the heat sink 20.

The fastener 40 may be integrally formed with the case 11. For example, the fastener 40 may be integrally formed during manufacture of the case 11, such as during a moulding process.

The fastener 40 may be mounted on the case 11, for example on the upper surface 12a of the case 11 or a side surface 13a, 13b, 13c and 13d of the case 11. For example, the fastener 40 may be attached to the case 11 by an adhesive such as glue or resin, or by welding.

Figure 3 shows the fastener 40 comprising a plurality of screws 41a, 41b. Each screw 41a, 41b is configured to mechanically cooperate with a corresponding fastener 25 of the heat sink 20 such that the case 11 and heat sink 20 are fastened together. For example, each screw 41a, 41b may couple with a corresponding female thread contained within an aperture 26a, 26b of the heat sink 20, as shown in Figure 3. In other examples, each screw 41a, 41b may be configured to pass through a corresponding aperture 26a, 26b of the heat sink 20 before mechanically cooperating with a nut (not shown) on the other side of the heat sink 20.

In the example shown in Figure 3, the case 11 of the integrated circuit package 1 comprises a plurality of apertures 42a, 42b corresponding to the plurality of screws 41a, 41b. Each screw 41a, 41b passes through a respective aperture 42a, 42b of the case 11 followed by a respective aperture 26a, 26b of the heat sink 20 until a head of the screw 41a, 41b contacts part of the case 11 adjacent the aperture 42a, 42b. In some examples, the screws 41a, 41b may pass through corresponding apertures (not shown) in the board 30.

The fastener 40 may be configured to couple the case 11 to the heat sink 20 such that a surface of the case 11 (i.e. the upper surface 12a) contacts a surface of the heat sink 20 (i.e. the lower surface 21). In some examples, a layer of thermal interface material (not shown) may be provided between the lower surface 21 of the heat sink 20 and the upper surface 12a of the case 11, such that thermal coupling between the case 11 and the heat sink 20 is increased.

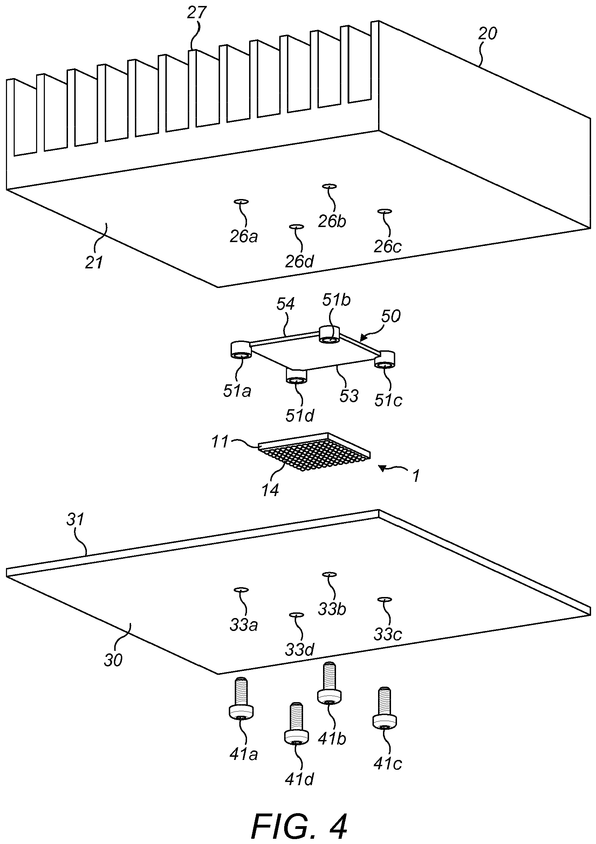

Although not shown in Figure 3, a lid 50 may be mounted to the upper surface 12a of the case 11 as described later with reference to Figure 4. A layer of thermal interface material may be provided between the lid 50 and the upper surface 12a of the case 11, to thermally couple the lid 50 to the case 11. A layer of thermal interface material may also be provided between the lid 50 and the lower surface 21 of the heat sink 20, to thermally couple the lid 50 to the heat sink 20.

The fastener 40 may comprise at least one screw 41a, 41b or at least one female screw thread. Although screws 41a, 41b have been discussed as the exemplary fastener 40 in relation to Figure 3, other suitable means could be used as the fastener 40 instead. For example, the fastener 40 could comprise one or more clips, locks, rivets, latches or the like.

The fastener 40 is configured to mechanically cooperate with a corresponding fastener 25 of the heat sink 20 such that the case 11 is fastened to the heat sink 20. For example where the fastener 40 comprises one or more screws 41a, 41b, each screw 41a, 41b is configured to mechanically cooperate with a corresponding female screw thread of the heat sink 20. Where the fastener 40 comprises a female screw thread, the female screw thread is configured to mechanically cooperate with a screw of the heat sink 20.

Fastening the case 11, and hence the integrated circuit package 1, to the heat sink 20 using the fastener 40 may reduce the tolerances between the heat sink 20 and integrated circuit package 1 and may reduce the gap 35 between the heat sink 20 and case 11. The dissipation of heat from the case 11 to the heat sink 20 may be improved. A thin layer of thermal interface material may be provided between the upper surface 12a of the case 11 and the lower surface 21 of the heat sink 20.

Figure 3 shows that the heat sink 20 is also coupled to the board 30 by a plurality of screws 32, or other coupling means. However, this is optional, and the heat sink 20 does not need to be directly coupled to the board 30.

Figure 4 is an exploded view of an apparatus according to exemplary embodiments. As discussed in relation to Figure 3, the apparatus comprises an integrated circuit package 1, which itself comprises a case 11 containing at least one integrated circuit. The package 1 may be configured to be mounted on the board 30, for example by soldering or another known method, such that a lower surface 12b of the case 11 is adjacent an upper surface 31 of the board 30.

Figure 4 shows the apparatus further comprising a lid 50, as discussed previously in relation to Figure 3. The lid 50 is configured to be mounted adjacent the upper surface 12a of the case 11 such that a surface of the lid 50 is parallel to the upper surface 12a of the case 11. The lid 50 is thermally conductive and is configured to dissipate heat from the case 11. The dissipated heat is transferred from the case 11 to the heat sink 20 via the lid 50.

The lid 50 may comprise a plate made from a metal such as aluminium or copper, or a thermally conductive composite. For example, aluminium may be chosen for low power applications while copper may be chosen for moderate power applications. In some examples, the lid 50 may comprise a heat pipe, such as a micro heat pipe, or a vapour chamber. A heat pipe or vapour chamber may be chosen for high power applications. In some examples, the lid 50 may be configured to circulate cooling liquid-.

The lid 50 may be directly coupled to the case 11. For example, the lid 50 may be mounted to the upper surface 12a of the case 11 using an adhesive such as glue. A layer of thermal interface material may be provided between the lid 50 and the upper surface 12a of the case 11, to thermally couple the lid 50 to the case 11. The lid 50 may be mounted on the case 11 before the integrated circuit package 1 is fastened to the heat sink 20.

Figure 4 shows the lid 50 comprising a plurality of apertures 51a,b,c,d configured to each receive a respective screw 41a,b,c,d. In this example four screws 41a,b,c,d and four respective apertures 51a,b,c,d are shown, however another number of screws 41a,b,c,d and respective apertures 51a,b,c,d may be used. Figure 4 shows the apertures 51a,b,c,d are arranged adjacent a periphery 53 of the lid, and hence adjacent a periphery of the upper surface 12a of the case 11. This ensures a secure coupling between the case 11 and the heat sink 20 once the heat sink 20 is installed, with a good tolerance.

A lower surface 21 of the heat sink 20 is arranged adjacent an upper surface 54 of the lid 50 - the opposite surface of the lid 50 to the case 11. The heat sink 20 is fastened to the case 11 by the screws 41a,b,c,d and apertures 51a,b,c,d. That is, each screw 41a,b,c,d is configured to pass through a respective aperture 33a,b,c,d in the board 30, followed by a respective aperture 51a,b,c,d of the lid 50, followed by a respective aperture 26a,b,c,d in the lower surface 21 of the heat sink 20. Each aperture 26a,b,c,d in the heat sink 20 comprises a female thread (not shown) configured to engage with the male thread of a respective screw 41a,b,c,d. Thus, when each screw 41a,b,c,d is screwed into the respective aperture 26a,b,c,d of the heat sink 20, the screw 41a,b,c,d is held in place by the female thread.

The heat sink 20 shown in Figure 4 is a straight fin heat sink comprising a plurality of fins 27 extending perpendicularly from an upper surface 28 of the heat sink 20, opposite the lower surface 21 of the heat sink 20. However, this heat sink 20 is shown by way of example only, and other types of heat sink 20 may be used instead, such as pin heat sinks and flared fin heat sinks.

A layer of thermal interface material may be provided between the lower surface 21 of the heat sink 20 and the upper surface 12a of the case 11.

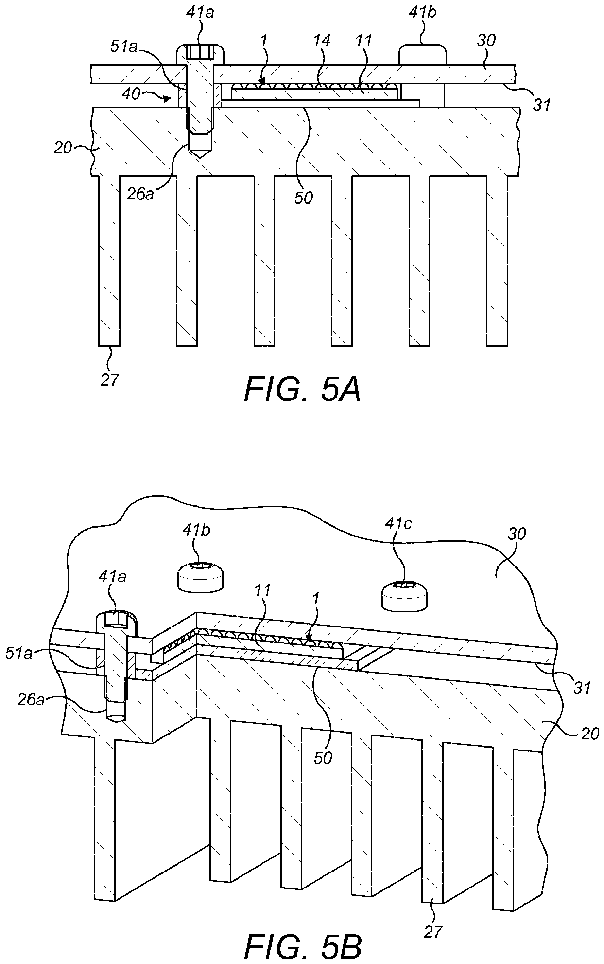

Figures 5A and 5B respectively show side-view cut-outs and perspective view cut-outs of the apparatus of Figure 4 once the heat sink 20, lid 50 and board 30 have been fastened together by the screws 41a,b,c,d.

Again, although screws 41a,b,c,d have been discussed as the exemplary fastener 40 in relation to Figures 4, 5A and 5B, a different fastener 40 could be used instead. For example, the fastener 40 could comprise one or more clips, locks, rivets, latches or the like.

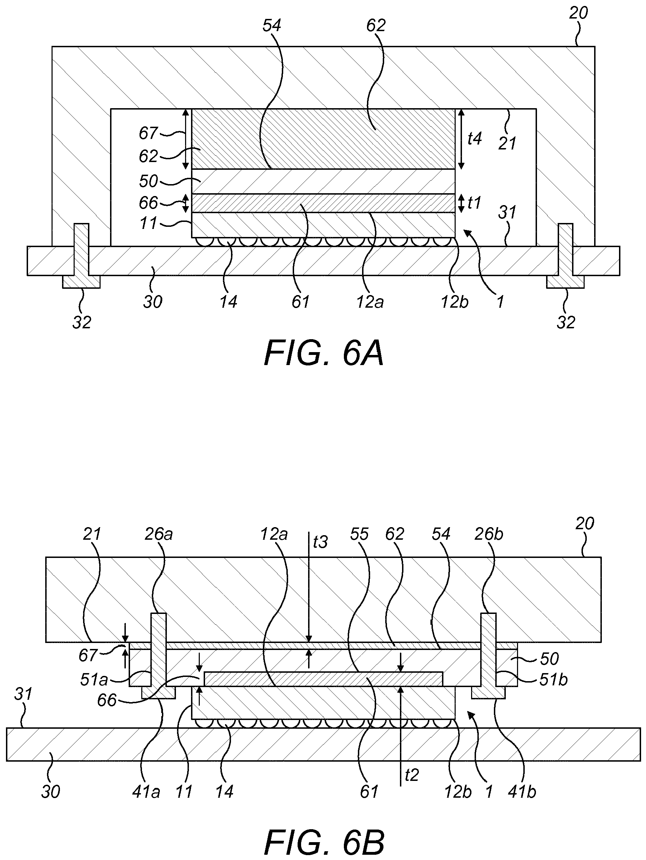

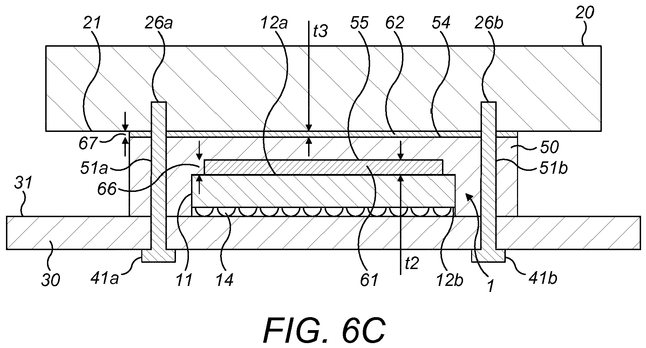

Figures 6A, 6B and 6C illustrate the thermal benefit of example embodiments of the present application.

Figure 6A shows a prior art example of an integrated circuit package 1 and a heat sink 20. An integrated circuit package 1 is mounted on a board 30 A lid 50 may be located between the upper surface 12a of the case 11 of the integrated circuit package 1 and the lower surface 21 of the heat sink 20. A first layer of thermal interface material 61 may be provided in the gap 66 between the upper surface 12a of the case 11 and the lid 50. The heat sink 20 is arranged such that a lower surface 21 of the heat sink 20 is adjacent an upper surface of the lid 50. A second layer of thermal interface material 62 may be provided in the gap 67 between the heat sink 20 and the lid 50. The thermal interface material of the first layer 61 and the second layer 62 may be the same type of thermal interface material or different types of thermal interface material.

The thermal resistance $R_{TIM}$ of a thermal interface layer may be derived using the following equation:

$$R_{TIM} = \frac{t}{kA}$$

where t is the thickness of the thermal interface layer, A is the cross sectional area of the thermal interface layer, and k is the thermal conductivity of the thermal interface layer.

Figure 6B shows an apparatus in accordance with example embodiments. As for Figure 6A, the integrated circuit package 1 is mounted on a board 30 A lid 50 is mounted on the case 11 of the integrated circuit package 1 such that a lower surface 55 of the lid 50 is adjacent an upper surface 12a of the case 11. A first layer of thermal interface material 61 may be provided in the gap 66 between the upper surface 12a of the case 11 and the lower surface 55 of the lid 50. The first layer of thermal interface material 61 may have the same thickness $t_2$ as the thickness $t_1$ of the first layer of thermal interface material 61 shown in Figure 6A, or a smaller thickness. In some examples, there may be no interface material 61 provided in the gap 66 between the upper surface 12a of the case 11 and the lower surface 55 of the lid 50.

However, unlike Figure 6A, Figure 6B shows that the heat sink 20 is fastened to the lid 20 by a fastener 40, in this case a plurality of screws 41a,b. A second layer of thermal interface material 62 may still be provided in the gap 67 between the heat sink 20 and the lid 50, however the thickness $t_3$ of the second layer of thermal interface material 62 may now be smaller than the thickness $t_4$ of the second layer of thermal interface material 62 shown in Figure 6A. The result is that $R_{TIM}$ may be reduced in Figure 6B as compared to Figure 6A.

Figure 6C is similar to Figure 6B, however here the lid 55 may also contact upper surface 31 of the circuit board 30, in a similar manner as shown in Figures 5A and 5B. The screws 41a,b pass through the circuit board 30 in a similar manner as shown in Figures 4A and 4B, followed by respective apertures 51a,b in the lid 50 and apertures 26a,b in the heat sink 20, to fasten the case to a heat sink.

$R_{TIM}$ may be further reduced by increasing the cross sectional area A of the lid 50, in particular the lower surface 55 of the lid 50, or by using a highly thermally conductive lid 50 such as a lid 50 comprising a micro channel heat pipe or vapour chamber.

According to examples, there is also provided a method comprising providing an apparatus as discussed previously, and fastening a heat sink 20 to the case 11 of the apparatus using the fastener 40 of the apparatus. For example, the method may involve screwing the heat sink 20 to the case 11 using one or more screws 52 such that the heat sink 20 is fastened to the case 11, and hence the integrated circuit package 1.

According to examples, there is also provided a system comprising an apparatus as previously discussed and a heat sink 20 fastened to the case 11 of the apparatus using the fastener 40 of the apparatus.

Some exemplary devices which may use a System on a Chip (SoC) include smartphones, televisions, games consoles, and personal computers, including desktops, laptops and tablets. These devices may comprise an apparatus or system as described herein.

It will be appreciated that the above described example embodiments are purely illustrative and are not limiting on the scope of the invention. Other variations and modifications will be apparent to persons skilled in the art upon reading the present application.

Moreover, the disclosure of the present application should be understood to include any novel features or any novel combination of features either explicitly or implicitly disclosed herein or any generalization thereof and during the prosecution of the present application or of any application derived therefrom, new claims may be formulated to cover any such features and/or combination of such features.

## Claims

1. An apparatus comprising:

   an integrated circuit package, wherein the integrated circuit package comprises:

   a case containing at least one integrated circuit; and
   a fastener configured to fasten the case to a heat sink.

2. An apparatus according to claim 1, wherein the fastener is integrally formed with the case.

3. An apparatus according to claim 1, wherein the fastener is directly mounted on the case.

4. An apparatus according to claim 3, wherein the fastener is mounted on the case by an adhesive.

5. An apparatus according to any preceding claim, wherein the fastener comprises at least one screw configured to fasten the case to the heat sink.

6. An apparatus according to claim 5, wherein the fastener comprises a plurality of screws arranged adjacent a periphery of an upper surface of the case and configured to fasten the case to the heat sink.

7. An apparatus according to any preceding claim, wherein the fastener comprises at least one female screw thread configured to fasten the case to the heat sink.

8. An apparatus according to any preceding claim, wherein the fastener comprises at least one aperture, wherein the at least one aperture is configured to receive a screw to fasten the case to the heat sink.

9. An apparatus according to any preceding claim, wherein the integrated circuit package further comprises a lid, wherein the lid is mounted on the case, and wherein the lid comprises the fastener.

10. An apparatus according to claim 9, wherein the fastener comprises a plurality of apertures arranged around a periphery of the lid and configured to each receive a respective screw to fasten the case to the heat sink.

11. An apparatus according to claim 9 or 10, wherein the lid comprises a metal plate, a heat pipe or a vapour chamber.

12. An apparatus according to claim 9, 10 or 11, further comprising a layer of thermal interface material between the case and the lid.

13. An apparatus according to any preceding claim, where the integrated circuit is a System on a Chip (SoC).

14. A system comprising an apparatus according to any one of claims 1 to 13 and a heat sink fastened to the case of the apparatus using the fastener of the apparatus.

15. A method comprising:

   providing an apparatus according to any of claims 1 to 13; and
   fastening a heat sink to the case of the apparatus using the fastener of the apparatus.

FIG. 1A

FIG. 1B

**FIG. 1C**

**FIG. 1D**

**FIG. 2**

**FIG. 3**

FIG. 4

## FIG. 5A

## FIG. 5B

**FIG. 6A**

**FIG. 6B**

FIG. 6C

Europäisches
Patentamt

European
Patent Office

Office européen
des brevets

## EUROPEAN SEARCH REPORT

Application Number

EP 17 20 7665

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/60138 A1 (CHIP COOLERS INC [US]) 16 August 2001 (2001-08-16) <br><br> * page 6, line 38; figure 2 * | 1-3, 5-11, 13-15 | INV. H01L23/40 H05K1/02 |
| X | US 2008/285239 A1 (YUN DONG-GOO [KR]) 20 November 2008 (2008-11-20) * paragraphs [0021], [0027], [0046]; figures 2,3 * | 1,3,5-15 | |
| X | US 2015/062820 A1 (LAM MANDY HIN [US] ET AL) 5 March 2015 (2015-03-05) * paragraphs [0020] - [0022]; figure 1B * | 1,3,5,6, 8-15 | |
| X | WO 93/16580 A1 (AAVID ENG INC [US]) 19 August 1993 (1993-08-19) * figure 1 * | 1-3,14, 15 | |

TECHNICAL FIELDS
SEARCHED (IPC)

H01L
H05K

The present search report has been drawn up for all claims

| Place of search | Date of completion of the search | Examiner |
|---|---|---|
| The Hague | 1 June 2018 | Gélébart, Jacques |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 17 20 7665

This annex lists the patent family members relating to the patent documents cited in the above-mentioned European search report.
The members are as contained in the European Patent Office EDP file on
The European Patent Office is in no way liable for these particulars which are merely given for the purpose of information.

01-06-2018

| Patent document cited in search report | | | Publication date | Patent family member(s) | | | Publication date |
|---|---|---|---|---|---|---|---|
| WO 0160138 | A1 | | 16-08-2001 | AU | 2973401 | A | 20-08-2001 |
| | | | | JP | 2003522423 | A | 22-07-2003 |
| | | | | WO | 0160138 | A1 | 16-08-2001 |
| US 2008285239 | A1 | | 20-11-2008 | KR | 20070055323 | A | 30-05-2007 |
| | | | | US | 2008285239 | A1 | 20-11-2008 |
| | | | | WO | 2007061245 | A1 | 31-05-2007 |
| US 2015062820 | A1 | | 05-03-2015 | NONE | | | |
| WO 9316580 | A1 | | 19-08-1993 | CA | 2129334 | A1 | 19-08-1993 |
| | | | | DE | 4390584 | T1 | 26-01-1995 |
| | | | | GB | 2278734 | A | 07-12-1994 |
| | | | | NL | 9320022 | A | 01-02-1995 |
| | | | | US | 5304735 | A | 19-04-1994 |
| | | | | WO | 9316580 | A1 | 19-08-1993 |

EPO FORM P0459

For more details about this annex : see Official Journal of the European Patent Office, No. 12/82